# EUROPEAN PATENT SPECIFICATION

(11) **EP 1 078 970 B1**
(45) Date of publication and mention of the grant of the patent: **17.03.2004**
(21) Application number: 00810727.8
(22) Date of filing: 16.08.2000
(51) Int. Cl.: C09K 11/06, C08G 61/12, H05B 33/14

(54) **DPP-containing conjugated polymers and electroluminescent devices**
DPP enthaltende konjugierte Polymere und elektrolumineszente Vorrichtungen
Polymères conjugés et dispositifs électroluminescentes contenant des groupes DPP

(30) Priority: 26.08.1999 EP 99810773
(43) Date of publication of application: 28.02.2001
(73) Proprietor: Ciba Specialty Chemicals Holding Inc., 4057 Basel (CH)
(72) Inventor: Tieke, Bernd, 50321 Brühl (DE); Beyerlein, Thomas, 50737 Köln (DE); Brütting, Wolfgang, 91344 Waischenfeld (DE); Forero-Lenger, Stefan, 95448 Bayreuth (DE)

(56) References cited:
- EP-A- 0 499 011
- EP-A- 0 787 730
- CHAN W -K ET AL: "RATIONAL DESIGNS OF MULTIFUNCTIONAL POLYMERS" JOURNAL OF THE AMERICAN CHEMICAL SOCIETY,US,AMERICAN CHEMICAL SOCIETY, WASHINGTON, DC, vol. 115, no. 25, page 11735-11743 XP000652156 ISSN: 0002-7863
- LUPING YU ET AL: "CONJUGATED PHOTOREFRACTIVE POLYMER" APPLIED PHYSICS LETTERS,US,AMERICAN INSTITUTE OF PHYSICS. NEW YORK, vol. 64, no. 19, page 2489-2491 XP000449535 ISSN: 0003-6951
- BAO, ZHENAN ET AL: "Exploration of the Stille Coupling Reaction for the Synthesis of Functional Polymers" J. AM. CHEM. SOC. (1995), 117(50), 12426-35, XP002127197
- LANGE G ET AL: "NEW DEEPLY COLOURED AND FLUORESCENT POLYMERS WITH 1,4-DIOXO-3,6-DIPHENYLPYRROLOU3,4-CPYRROLE UNITS IN THE MAIN CHAIN" MACROMOLECULAR CHEMISTRY AND PHYSICS,DE,WILEY VCH, WEINHEIM, vol. 200, no. 1, page 106-112 XP000801445 ISSN: 1022-1352

## Description

The present invention relates to diketopyrrolopyrrole (DPP) based polymers and copolymers comprising the following units 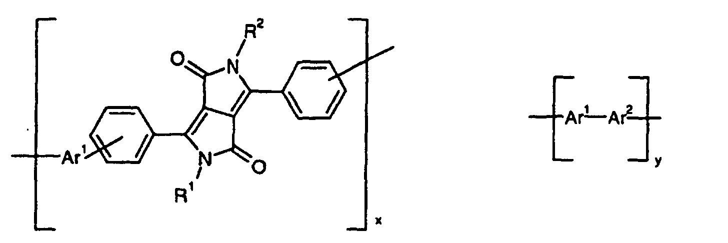 wherein x is chosen in the range of from 0.005 to 1, preferably from 0.01 to 1, and y from 0.995 to 0, preferably 0.99 to 0, and wherein x + y = 1, and
wherein Ar¹ and Ar² independently from each other stand for 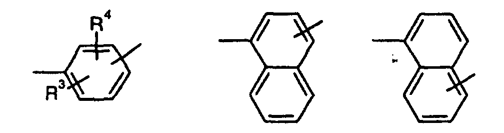 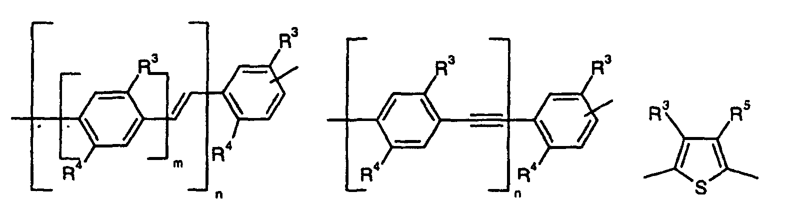 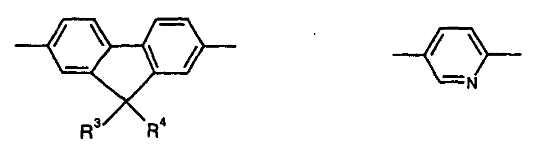 and m, n being numbers from 1 to 10, and
R¹ and R² independently from each other stand for H, C₁-C₁₈alkyl, -C(O)O-C₁-C₁₈alkyl, perfluoro-C₁-C₁₂alkyl, unsubstituted C₆-C₁₂aryl or C₆-C₈aryl substituted one to three times with C₁-C₁₂alkyl, C₁-C₁₂alkoxy, or halogen, C₁-C₁₂alkyl-C₆-C₁₂aryl, or C₆-C₁₂aryl-C₁-C₁₂alkyl, R³ and R⁴ stand for hydrogen, C₁-C₁₂alkyl, C₁-C₁₂alkoxy, unsubstituted C₆-C₁₂aryl or C₆-C₈aryl substituted one to three times with C₁-C₁₂alkyl, C₁-C₁₂alkoxy, or halogen or perfluoro-C₁-C₁₂alkyl, and
R⁵ preferably stands for C₁-C₁₂alkyl, C₁-C₁₂alkoxy, unsubstituted C₆-C₁₂aryl or one to three times with C₁-C₁₂alkyl, C₁-C₁₂alkoxy, or halogen substituted C₆-C₁₂aryl, or perfluoro-C₁-C₁₂alkyl,
blends of such polymers and copolymers with other polymers, their use for the preparation of electroluminescent ("EL") devices and EL devices comprising such polymers or copolymers.

EP-A 787,730 describes a polyacrylate and a polyurethane obtained by the polymerization of a DPP of formula la 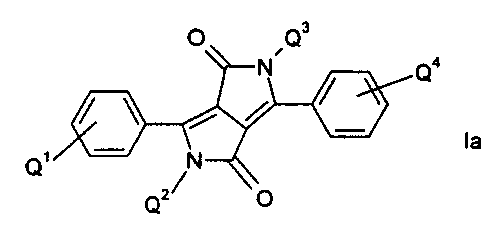 wherein Q₁ and Q₄ independently of each other stand for a polymerizable reactive group, and Q₂ and Q₃ independently of each other stand for hydrogen, C₁₂-C₂₄alkyl, C₆-C₂₄alkyl which is interrupted one or more times by O or S, or are a group of the formula 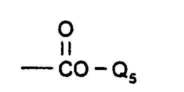 in which Q₅ is C₄-C₁₈alkyl or C₅-C₁₀cycloalkyl.

Though it is mentioned that compounds la can be used for the preparation of photo- and electroconductive polymers, no corresponding examples are given. Further, no teaching is given of how to prepare EL devices comprising DPP-based polymers and of how to select the appropriate DPP-monomers resp. DPP-polymers.

Macromol. Chem. Phys. 200 (1999) 106-112 describes fluorescent DPP-polymers obtainable by the copolymerization of bifunctional monomeric DPP-derivatives, wherein the functional groups are attached to the N-atoms of the DPP-molecule, with diisocyanates or di-ols or di-acids.

J. Amer. Chem. Soc. 1995, 117, 12426-12435 D3 relates to the exploration of the palladium catalysed Stille coupling reaction for the synthesis of functional polymers. In Scheme 7 of D3 the synthesis of the following polymer is presented:

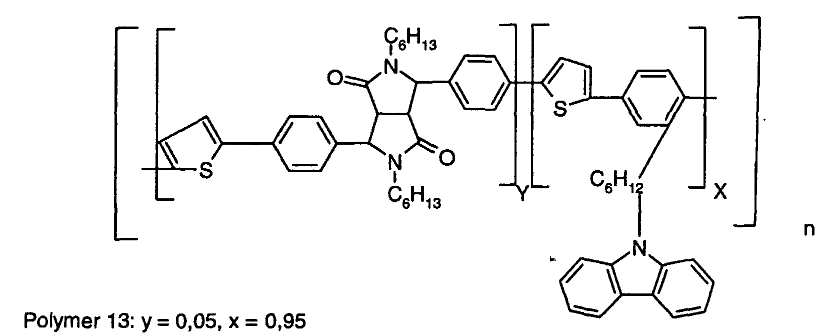

No teaching is given whether the described polymers can be used in EL devices.

JACS 115 (1993) 11735-11743 describes DPP-polymers demonstrating photorefractivity, i.e. exhibiting photoconductivity and second order non-linear-optical activity. Although the photoconductive properties are measured using a device similar to an EL device, i.e. irradiating the device with a laser beam and then measuring the current resulting from this irradiation, no measurements were carried out with regard to electroluminescence. Further, no teaching is given of how to select other DPP-polymers.

In Applied Physics Letters 1994, 64, S. 2489-2491 further studies, i.e. two-beam coupling experiments, using polymers disclosed in JACS 115 (1993) 11735-11743 are performed to study photorefractivity. The two-beam coupling experiments demonstrated asymmetric energy exchange under zero field, i.e. photorefractivity of the polymers disclosed in JACS 115 (1993) 11735-11743.

Adv. Mater. 4 (1992) 36-37 describes poly(p-phenylene)-based EL devices emitting blue light. However, no teaching and no motivation are given of how to modify the used polymers. Further, λₘₐₓ of electroluminescence is in the blue region.

Hence, an object of the present invention was to provide novel DPP-based polymers and copolymers, preferably exhibiting a λₘₐₓ of electroluminescence which is not in the blue region, i.e. not between 400 to 470 nm, but preferably in the range of from 500 to 800, more preferably of from 600 to 750 nm, and its use in electronic and photonic devices such as diodes, light-emitting diodes, photodiodes, field-effect transistors, polymer grid triodes, light-emitting electrochemical cells, optocouplers, and lasers. Further, the intensity of the electroluminescence of the novel polymers should be improved with regard to poly(1,4-phenylene). In addition, the processability into thin films by spin-coating and solution coating of the novel polymers should be improved with regard to poly(1,4-phenylene).

Accordingly, the above-mentioned DPP-based polymers have been found.

In addition, blends comprising the inventive polymers, EL devices comprising the inventive polymers and the use of DPP based polymers have been found, too.

Preferably, Ar¹ stands for

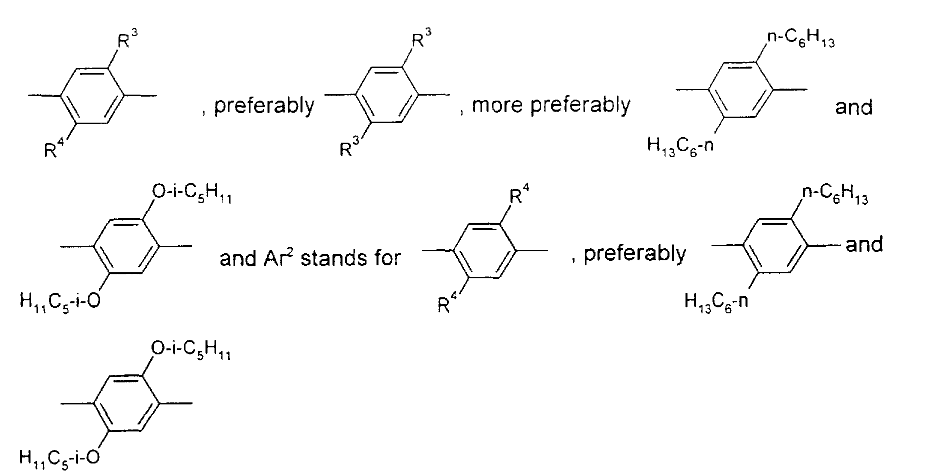

Preferably, R¹ and R² independently from each other stand for H, C₁-C₁₂alkyl, -C(O)O-C₁-C₁₂alkyl, perfluoro-C₁-C₁₂alkyl, unsubstituted C₆-C₁₂aryl or one to three times with C₁-C₁₂alkyl, C₁-C₁₂alkoxy, or halogen substituted C₆-C₁₂aryl, C₁-C₁₂alkyl-C₆-C₁₂aryl, or C₆-C₁₂aryl-C₁-C₁₂alkyl,
R³ and R⁴ preferably stand for hydrogen, C₁-C₁₂alkyl, C₁-C₁₂alkoxy, unsubstituted C₆-C₁₂aryl or one to three times with C₁-C₁₂alkyl, C₁-C₁₂alkoxy, or halogen substituted C₆-C₁₂aryl or perfluoro-C₁-C₁₂alkyl, and
R⁵ preferably stands for C₁-C₁₂alkyl, C₁-C₁₂alkoxy, unsubstituted C₆-C₁₂aryl or one to three times with C₁-C₁₂alkyl, C₁-C₁₂alkoxy, or halogen substituted C₆-C₁₂aryl, or perfluoro-C₁-C₁₂alkyl.

A preferred embodiment concerns a copolymer comprising the following units 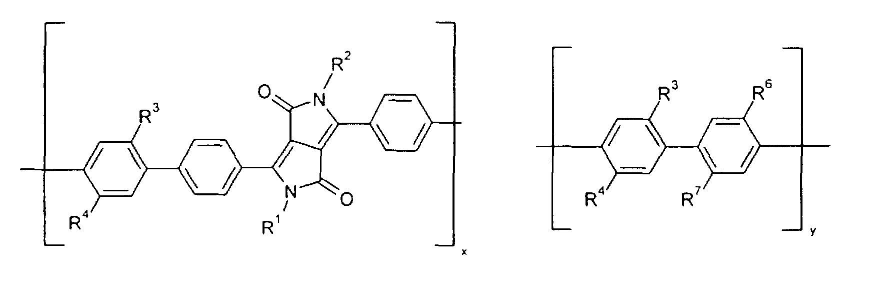 wherein R⁶ and R⁷, independently from each other, have the meaning of hydrogen, C₁-C₁₂alkyl, C₁-C₁₂alkoxy, unsubstituted C₆-C₁₂aryl or one to three times with C₁-C₁₂alkyl, C₁-C₁₂alkoxy, or halogen substituted C₆-C₁₂aryl or perfluoro-C₁-C₁₂alkyl, more preferably 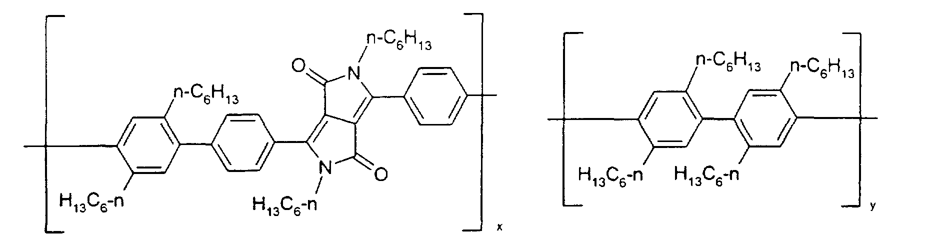 and 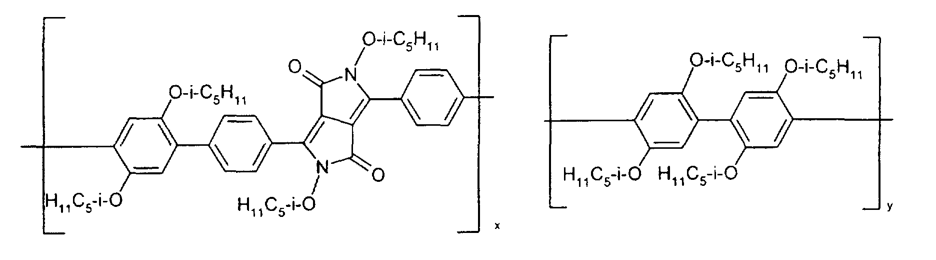 C₁-C₁₈alkyl stands for methyl, ethyl, n-, i-propyl, n-, i-, sec.-, tert.-butyl, n-, i-, neo-pentyl, n-hexyl, n-heptyl, n-octyl, 2-ethylhexyl, n-nonyl, n-decyl, 3,7-dimethyloctyl, n-undecyl, n-dodecyl, n-tridecyl, n-tetradecyl, n-pentadecyl, n-hexadecyl, n-heptadecyl, n-octadecyl, preferably for C₁-C₁₂alkyl such as methyl, ethyl, n-, i-propyl, n-, i-, sec.-, tert.-butyl, n-, i-, neo-pentyl, n-hexyl, n-heptyl, n-octyl, 2-ethylhexyl, n-nonyl, n-decyl, 3,7-dimethyloctyl, n-undecyl, or n-dodecyl.

perfluoro-C₁-C₁₂alkyl stands for fully or partially fluorinated C₁-C₁₂alkyl such as fluoromethyl, trifluoromethyl, pentafluoroethyl, heptafluoropropyl, or nonafluorobutyl.

C₁-C₁₂alkoxy stands for methoxy, ethoxy, n-, i-propoxy, n-, i-, sek.- or tert.-butoxy, n-, i-pentoxy, n-hexoxy, n-heptoxy-, n-octoxy, 2-ethylhexoxy, n-nonoxy, n-decoxy, 3,7-dimethyloctoxy, n-undecoxy, n-dodecoxy, preferably for C₄-C₁₂alkoxy such as n-, i-, sec.- or tert.-butoxy, n-, i-pentoxy, n-hexoxy, n-heptoxy-, n-octoxy, 2-ethylhexoxy, n-nonoxy, n-decoxy, 3,7-dimethyloctoxy, n-undecoxy, n-dodecoxy.

C₆-C₁₂aryl is typically phenyl, 1-naphthyl, 2-naphthyl, or 4-biphenyl.

C₁-C₁₂alkyl-C₆-C₁₂aryl stands for e.g. 2-, 3-, 4-methyl-phenyl, 2-, 3-, 4-ethyl-phenyl, 2-, 3-, 4-n-propyl-phenyl, 2-, 3-, 4-i-propyl-phenyl, 2-, 3-, 4-n-butyl-phenyl, 2-, 3-, 4-tert.-butyl-phenyl, 1-, 2-methyl-naphthyl, 1-, 2-ethyl-naphthyl, 1-, 2-n-propyl-naphthyl, 1-, 2-i-propyl-naphthyl, 1-, 2-n-butyl-naphthyl, 1-, 2-tert.-butyl-phenyl.

C₆-C₁₂aryl-C₁-C₁₂alkyl stands for e.g. benzyl, 2-benzyl-2-propyl, β-phenyl-ethyl, α,α-dimethylbenzyl, ω-phenyl-butyl, ω,ω-dimethyl-ω-phenyl-butyl, ω-phenyl-dodecyl, ω-phenyl-octadecyl, ω-phenyl-eicosyl or ω-phenyl-docosyl, preferably C₇-C₁₈aralkyl such as benzyl, 2-benzyl-2-propyl, β-phenyl-ethyl, α,α-dimethylbenzyl, ω-phenyl-butyl, ω,ω-dimethyl-ω-phenyl-butyl, ω-phenyl-dodecyl or ω-phenyl-octadecyl, and particularly preferred C₇-C₁₂aralkyl such as benzyl, 2-benzyl-2-propyl, β-phenyl-ethyl, α,α-dimethylbenzyl, ω-phenyl-butyl, or ω,ω-dimethyl-ω-phenyl-butyl.

The inventive polymers and copolymers (hereinafter the term polymer comprises the term copolymer) usually have a molecular weight M_{w} in the range of from 1,000 to 1,000,000 g/mol, preferably from 2,000 to 100,000 g/mol, most preferably from 2,000 to 50,000 g/mol.

A preferred embodiment of the present invention relates to a process for the preparation of a DPP polymer, comprising the following units: 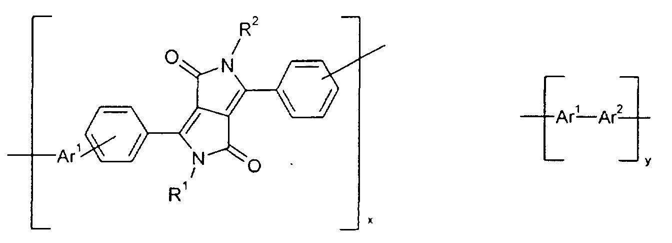 which comprises reacting a DPP derivative of formula II 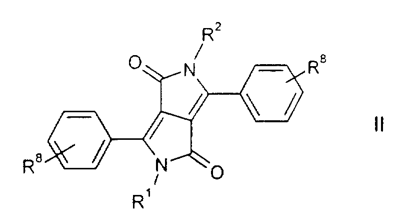 wherein
R⁸ stands for halogen such as chloro or bromo, preferably bromo, or E having the meaning of 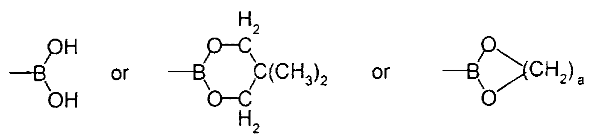 wherein a is 2 or 3,
with boronic acid derivative III 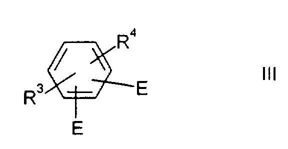 or - in case R⁸ is not halogen - 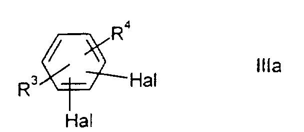 wherein Hal stands for halogen as defined above, preferably for bromo,
and optionally with dihalophenyl compound IV

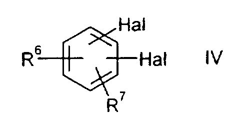

Preferably, the reaction is carried out in the presence of an organic solvent such as an aromatic hydrocarbon or a usual polar organic solvent such as benzene, toluene, xylene, tetrahydrofurane, or dioxane, or mixtures thereof, most preferred toluene. Usually, the amount of the solvent is chosen in the range of from 1 to 10 I per mol of boronic acid derivative III.

Also preferred, the reaction is carried out under an inert atmosphere such as nitrogen, or argon.

Further, it is preferred to carry out the reaction in the presence of an aqueous base such as an alkali metal hydroxide or carbonate such as NaOH, KOH, Na₂CO₃, K₂CO₃ and the like, preferably an aqueous K₂CO₃ solution is chosen. Usually, the molar ratio of the base to compound III is chosen in the range of from 0.5:1 to 50:1.

Generally, the reaction temperature is chosen in the range of from 40 to 180°C, preferably under reflux conditions.

Preferred, the reaction time is chosen in the range of from 1 to 80 hours, more preferably from 20 to 72 hours.

In a preferred embodiment a usual catalyst for coupling reactions or for polycondensation reactions is used, preferably Pd-based catalyst such as known tetrakis(triarylphosphonium)-palladium, preferably (Ph₃P)₄Pd and derivatives thereof. Usually, the catalyst is added in a molar ratio from inventive DPP polymer to the catalyst in the range of from 100:1 1 to 10:1, preferably from 50:1 to 30:1.

Also preferred, the catalyst is added as in solution or suspension. Preferably, an appropriate organic solvent such as the ones described above, preferably benzene, toluene, xylene, THF, dioxane, more preferably toluene, or mixtures thereof, is used. The amount of solvent usually is chosen in the range of from 1 to 10 I per mol of boronic acid derivative III. The obtained inventive DPP polymer can be isolated by well-known methods. Preferably, after cooling down the reaction mixture to room temperature, it is poured into acetone and the obtained precipitation preferably is filtered off, washed and dried.

DPP derivatives II are known and can be prepared according to methods known in the art, e.g. described in US 4,579,949 or in US 4,585,878, i.e. by reacting 2 moles of an appropriate nitrile or a Schiff base with one mole of a succinic acid diester in the presence of a base and an organic solvent.

Another embodiment of the present invention relates to electroluminescent devices comprising the inventive polymers.

Typical constitutions of latest organic electroluminescent devices are:
(i) an anode/a hole transporting layer/an electron transporting layer/a cathode, in which the inventive polymers are used either as positive-hole transport compounds, which is exploited to form the light emitting and hole transporting layers, or as electron transport compounds, which can be exploited to form the light-emitting and electron transporting layers, and
(ii) an anode/a hole transporting layer/a light-emitting layer/optionally an electron transporting layer/a cathode,
in which the inventive polymers form the light-emitting layer regardless of whether they exhibit positive-hole or electron transport properties in this constitution.

It is possible that the light-emitting layer can consist of two or more inventive polymers for energy donor(s) and electron acceptor(s).

The devices can be prepared in several ways. Usually, vacuum evaporation is extensively used for the preparation. Preferably, the organic layers are laminated in the above order on a commercially available indium-tin-oxide ("ITO") or fluorinated tin-oxide ("FTO") glass substrate held at room temperature, which work as the anode in the constitutions. The membrane thickness is preferably in the range of 1 to 10,000 nm, more preferably 1 to 5,000 nm, more preferably 1 to 1,000 nm, more preferably 1 to 500 nm. The cathode metal such as Al, Ca, Mg/Ag alloy and Li-Al binary system of 30 to 200 nm is laminated on the top of the organic layers. The vacuum during the deposition is preferably 0.1333 Pa (1x 10⁻³ Torr), more preferably 1.333x 10⁻³ Pa (1x 10⁻⁵ Torr), more preferably 1.333x 10⁻⁴ Pa (1x 10⁻⁶ Torr).

As anode usual anode materials which possess high work function such as metals like gold, silver, copper, aluminum, indium, iron, zinc, tin, chromium, titanium, vanadium, cobalt, nickel, lead, manganese, tungsten and the like, metallic alloys such as magnesium/copper, magnesium/silver, magnesium/aluminum, aluminum/indium and the like, semiconductors such as Si, Ge, GaAs and the like, metallic oxides such as ITO, FTO, ZnO and the like, metallic compounds such as Cul and the like, and furthermore, electroconducting polymers such polyacetylene, polyaniline, polythiophene, polypyrrole, polyparaphenylene and the like, preferably ITO or FTO, most preferably ITO or FTO on glass as substrate can be used

Of these electrode materials, metals, metallic alloys, metallic oxides and metallic compounds can be transformed into electrodes, for example, by means of the sputtering method. In the case of using a metal or a metallic alloy as a material for an electrode, the electrode can be formed also by the vacuum deposition method. In the case of using a metal or a metallic alloy as a material forming an electrode, the electrode can be formed, furthermore, by the chemical plating method (see for example, Handbook of Electrochemistry, pp 383-387, Mazuren, 1985). In the case of using an electroconducting polymer, an electrode can be made by forming it into a film by means of anodic oxidation polymerization method onto a substrate which is previously provided with an electroconducting coating. The thickness of an electrode to be formed on a substrate is not limited to a particular value, but, when the substrate is used as a light emitting plane, the thickness of the electrode is preferably within the range of from 1 nm to 100 nm, more preferably, within the range of from 5 to 50 nm so as to ensure transparency.

In a preferred embodiment ITO is used on a substrate having an ITO film thickness in the range of from 10 nm (100 Å) to 1 µm (10000 Å), preferably from 20 nm (200 Å) to 500 nm (5000 Å). Generally, the sheet resistance of the ITO film is chosen in the range of not more than 100 Ω/cm², preferred from not more than 50 Ω/cm².
Such anodes are commercially available e.g. from e.g. Japanese manufacturers such as Geomatech Co.Ltd., Sanyo Vacuum Co. Ltd., Nippon Sheet Glass Co. Ltd.

As substrate either an electroconducting or electrically insulating material can be used. In case of using an electroconducting substrate, a light emitting layer or a positive hole transporting layer is directly formed thereupon, while in case of using an electrically insulating substrate, an electrode is firstly formed thereupon and then a light emitting layer or a positive hole transporting layer is superposed.

The substrate may be either transparent, semi-transparent or opaque. However, in case of using a substrate as an indicating plane, the substrate must be transparent or semi-transparent. Transparent electrically insulating substrates are, for example, inorganic compounds such as glass, quartz and the like, organic polymeric compounds such as polyethylene, polypropylene, polymethylmethacrylate, polyacrylonitrile, polyester, polycarbonate, polyvinylchloride, polyvinylalcohol, polyvinylacetate and the like. Each of these substrates can be transformed into a transparent electroconducting substrate by providing it with an electrode according to one of the methods described above.

As examples of semi-transparent electrically insulating substrates, there are inorganic compounds such as alumina, YSZ (yttrium stabilized zirconia) and the like, organic polymeric compounds such as polyethylene, polypropylene, polystyrene, epoxy resin and the like. Each of these substrates can be transformed into a semi-transparent electroconducting substrate by providing it with an electrode according to one of the abovementioned methods.

As examples of opaque electroconducting substrates, there are metals such as aluminum, indium, iron, nickel, zinc, tin, chromium, titanium, copper, silver, gold, platinum and the like, various electroplated metals, metallic alloys such as bronze, stainless steel and the like, semiconductors such as Si, Ge, GaAs, and the like, electroconducting polymers such as polyaniline, polythiophene, polypyrrole, polyacetylene, polyparaphenylene and the like.

A substrate can be obtained by forming one of the above listed substrate materials to a desired dimension. It is preferred that the substrate has a smooth surface. Even if it has a rough surface, however, it will not cause any problem for practical use, provided that it has round unevenness having a curvature of not less than 20 µm. As for the thickness of the substrate, there is no restriction as far as it ensures sufficient mechanical strength.
As cathode usual cathode materials which possess low work function such as alkali metals, earth alkaline metals, group 13 elements, silver, and copper as well as alloys or mixtures thereof such as sodium, lithium, potassium, sodium-potassium alloy, magnesium, magnesium-silver alloy, magnesium-copper alloy, magnesium-aluminum alloy, magnesium-indium alloy, aluminum, aluminum-aluminum oxide alloy, aluminum-lithium alloy, indium, calcium, and materials exemplified in EP-A 499,011 such as electroconducting polymers e.g. polypyrrole, polythiophene, polyaniline, polyacetylene etc., preferably Al, Ca, Mg/Ag alloys, or Li-Al compositions can be used.

Such cathodes can be deposited on the foregoing electron transporting layer by known vacuum deposition techniques described above.

In a preferred ambodiment of this invention a light-emitting layer can be used between the hole transporting layer and the electron transporting layer (optionally) resp. cathode. Usually it is prepared by forming a thin film of an inventive DPP polymer on the hole transporting layer.

As methods for forming said thin film, there are, for example, the vacuum deposition method, the spin-coating method, the casting method, the Langmuir-Blodgett ("LB") method and the like. Among these methods, the vacuum deposition method, the spin-coating method and the casting method are particularly preferred in view of ease in operation and cost.

In case of forming a thin film using an inventive DPP polymer by means of the vacuum deposition method, the conditions under which the vacuum deposition is carried out are usually strongly dependent on the properties, shape and crystalline state of the compound. However, optimum conditions can be selected for example within the range of from 100 to 400°C in temperature for the heating boat, -100 to 350°C in substrate temperature, 1.33x10⁴ Pa (1x10² Torr) to 1.33x10⁻⁴ Pa (1x10⁻⁶ Torr) in pressure and 1 pm to 6 nm/sec in deposition rate.

In an organic EL element, the thickness of the light emitting layer thereof is one of the factors determining its light emission properties. For example, if a light emitting layer is not sufficiently thick, a short circuit can occur quite easily between two electrodes sandwiching said light emitting layer, and therefor, no EL emission is obtained. On the other hand, if the light emitting layer is excessively thick, a large potential drop occurs inside the light emitting layer because of its high electrical resistance, so that the threshold voltage for EL emission increases. Accordingly, it is necessary to limit the thickness of an organic light emitting layer within the range of from 5 nm to 5 µm. A preferable thickness is within the range of from 10 nm to 500 nm.

In the case of forming a light emitting layer by using the spin-coating method and the casting method, the coating can be carried out using a solution prepared by dissolving the inventive DPP polymers in a concentration of from 0.0001 to 90% by weight in an appropriate organic solvent such as benzene, toluene, xylene, tetrahydrofurane, methyltetrahydrofurane, N,N-dimethylformamide, dichloromethane, dimethylsulfoxide and the like. Herein, the higher the concentration of the inventive DPP polymers, the thicker the resulting film, while the lower the concentration, the thinner the resulting film. However, if the concentration exceeds 90% by weight, the solution usually is so viscous that it no longer permits forming a smooth and homogenous film. On the other hand, as a rule, if the concentration is less than 0.0001 % by weight, the efficiency of forming a film is too low to be economical. Accordingly, a preferred concentration of the inventive DPP polymers is within the range of from 0.01 to 80% by weight.

In the case of using the above spin-coating or casting method, it is possible to further improve the homogeneity and mechanical strength of the resulting layer by adding a polymer binder in the solution for forming the light emitting layer. In principle, any polymer binder may be used, provided that it is soluble in a solvent in which DPP I is dissolved. Examples of such polymer binders are polycarbonate, polyvinylalcohol, polymethacrylate, polymethylmeth-acrylate, polyester, polyvinylacetate, epoxy resin and the like. A solution for forming a light emitting layer may have any concentrations of the inventive DPP polymers, of a polymer binder and solvent. However, if the solid content composed of the polymer binder and inventive DPP polymer exceeds 99% by weight, the fluidity of the solution is usually so low that it is impossible to form a light emitting layer excellent in homogeneity. On the other hand, if the content of inventive DPP polymer is substantially smaller than that of the polymer binder, in general the electrical resistance of said layer is very large, so that it does not emit light unless a high voltage is applied thereto. Furthermore, since the concentration of inventive DPP polymer in the layer is small in this case, its light emission efficiency is relatively low. Accordingly, the preferred composition ratio of a polymer binder to inventive DPP polymer is chosen within the range of from 10:1 1 to 1:50 by weight, and the solid content composed of both components in the solution is preferably within the range of from 0.01 to 80% by weight, and more preferably, within the range of about 0.1 to 60% by weight.

In the case of forming a light-emitting layer by the spin-coating method or casting method, the thickness of said layer may be selected in the same manner as in the case of forming a light emitting layer by the vacuum deposition method. That is, the thickness of the layer preferably is chosen within the range of from 5 nm to 5 µm, and more preferably, within the range of from 10 nm to 500 nm.

As positive hole-transporting layers known organic hole transporting compounds such as polyvinyl carbazole, 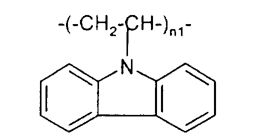 a triphenylamine derivative ("TPD") compound disclosed in J.Amer.Chem.Soc. 90 (1968) 3925 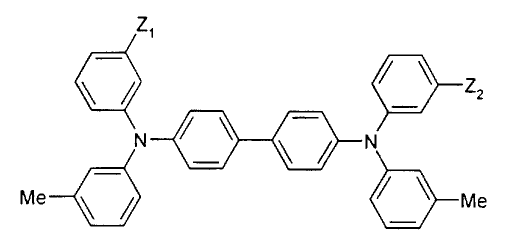 wherein Z₁ and Z₂ each represent a hydrogen atom or a methyl group;
a compound disclosed in J. Appl. Phys. 65(9) (1989) 3610 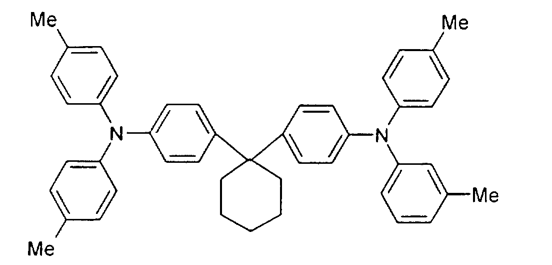 a stilbene based compound 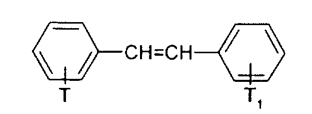 wherein T and T₁ stand for an organic rest,
poly(dioxyethylene thienylene) ("PEDOT"),
a hydrazone based compound 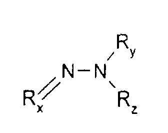 and the like.

Compounds to be used as a positive hole transporting material are not restricted to the above listed compounds. Any compound having a property of transporting positive holes can be used as a positive hole transporting material such as triazole derivatives, oxadiazole derivatives, imidazole derivatives, polyarylalkane derivatives, pyrazoline derivative, pyrazolone derivatives, phenylene diamine derivatives, arylamine derivatives, amino substituted chalcone derivatives, oxazole derivatives, stilbenylanthracene derivatives, fluorenone derivatives, hydrazone derivatives, stilbene derivatives, copolymers of aniline derivatives, electro-conductive oligomers, particularly thiophene oligomers, porphyrin compounds, aromatic tertiary amine compounds, stilbenyl amine compounds etc. Particularly, aromatic tertiary amine compounds such as N,N,N',N'-tetraphenyl-4,4'-diaminobiphenyl, N,N'-diphenyl-N,N'-bis(3-methylphenyl)- 4,4'-diaminobiphenyl (TPD), 2,2'-bis(di-p-torylaminophenyl)propane, 1,1'-bis(4-di-torylaminophenyl)-4-phenylcyclohexane, bis(4-dimethylamino-2-methylphenyl)phenylmethane, bis(4-di-p-tolylaminophenyl)phenylmethane, N,N'-diphenyl-N,N'-di(4-methoxyphenyl)-4,4'-diaminobiphenyl, N,N,N',N'-tetraphenyl-4,4'-diaminodiphenylether, 4,4'-bis(diphenylamino)quaterphenyl, N,N,N-tri(p-tolyl)amine, 4-(di-p-tolylamino)-4'-[4-(di-p-tolylamino)stilyl]stilbene, 4-N,N-diphenylamino-(2-diphenylvinyl)benzene, 3-methoxy-4'-N,N-diphenylaminostilbene, N-phenylcarbazole etc.

Furthermore, 4,4'-bis[N-(1-naphtyl)-N-phenylamino]biphenyl disclosed in US 5,061,569, the compounds in which three triphenylamine units are bound to a nitrogen atom like "star-burst" structure e.g. 4,4',4"-tris[N-(3-methylphenyl)-N-phenylamino]triphenylamine disclosed in EP-A 508,562.

A positive hole transporting layer can be formed by preparing an organic film containing at least one positive hole transporting material on the anode. The positive hole transporting layer can be formed by the vacuum deposition method, the spin-coating method, the casting method, the LB method and the like. Of these methods, the vacuum deposition method, the spin-coating method and the casting method are particularly preferred in view of ease and cost.

In the case of using the vacuum deposition method, the conditions for deposition may be chosen in the same manner as described for the formation of a light emitting layer (see above). If it is desired to form a positive hole transporting layer comprising more than one positive hole transporting material, the coevaporation method can be employed using the desired compounds.

In the case of forming a positive hole transporting layer by the spin-coating method or the casting method, the layer can be formed under the conditions described for the formation of the light emitting layer (see above).

As in the case of forming a light emitting layer using a solution containing a polymer binder, a smoother and more homogeneous positive hole transporting layer can be formed by using a solution containing a binder and at least one positive hole transporting material. The coating using such a solution can be performed in the same manner as in cases of forming a light emitting layer using a polymer binder. Any polymer binder may be used, provided that it is soluble in a solvent in which at least one positive hole transporting material is dissolved. Examples of appropriate polymer binders and of appropriate and preferred concentrations are given above when describing the formation of a light emitting layer.
The thickness of a positive hole transporting layer is preferably chosen in the range of from 0.5 to 1000 nm, preferably from 1 to 100 nm, more preferably from 2 to 50 nm.

As electron transporting materials for an electron-transporting layer it is preferred to have a high electron injection efficiency from the cathode and a high electron mobility. The following materials can be exemplified for electron transporting materials: tris(8-hydroxyquinolinoato)-aluminum(III) and its derivatives, bis(10-hydroxybenzo[h]quinolinolato)beryllium(II) and its derivatives, oxadiazole derivatives such as 2-(4-biphenyl)-5-(4-tert.-butylphenyl)-1,3,4-oxadiazole and its dimer systems such as 1,3-bis(4-tert.-butylphenyl-1,3,4)oxadiazolyl)-biphenylene and 1,3-bis(4-tert.-butylphenyl-1,3,4-oxadiazolyl)phenylene, triazole derivatives, phenanthroline derivatives or perylene tetracarboxylic acid derivatives such as disclosed in Appl. Phys. Lett. 48 (2) (1986) 183.

An electron transporting layer can be formed by preparing an organic film containing at least one electron transporting material on the hole transporting layer or on the light-emitting layer. The electron transporting layer can be formed by the vacuum deposition method, the spin-coating method, the casting method, the LB method and the like.

As in the case of forming a light emitting layer or a positive hole transporting layer by using a solution containing a polymer binder, a smoother and more homogeneous electron transporting layer can be formed by using a solution containing a binder and at least one electron transporting material.

In general, the inventive polymers exhibit a molar absorption coefficient in the range of from 10³ to 10⁶ [10³ cm² mol⁻¹].

A further preferred embodiment relates to the use of the inventive polymers in electronic and photonic devices such as diodes, light-emitting diodes, photodiodes, field-effect transistors, polymer grid triodes, light-emitting electrochemical cells, optocouplers and lasers.

A further embodiment of the present invention relates to electronic and photonic devices such as diodes, light-emitting diodes, photodiodes, field-effect transistors, polymer grid triodes, light-emitting electrochemical cells, optocouplers and lasers comprising the inventive polymers.

The inventive polymers exhibit an improved processability and an improved electroluminescence intensity by a factor of 10² to 10⁴ with regard to poly(1,4-phenylene).

### Examples

Example 1: x moles of 1.4-diketo-2.5-di(n-hexyl)-3.6-di(4-bromophenyl)pyrrolo-[3.4-c]pyrrole (prepared according to the method described in US 4,579,949, e.g. in ex. 25 or 44), (x +y) moles of 2.5-di-n-hexylbenzene-1.4-bis(boronic acid) (prepared according Makromol. Chem. 191 (1990) 1991) and y moles of 2.5-dibromo-1.4-di-n-hexylbenzene (Synthesis (1988) 386-388) are dissolved in toluene (5 ml/mmol boronic acid derivative) under nitrogen and a 1 N solution of potassium carbonate in water (5 ml/mmol boronic acid derivative) is added. The solution is heated to reflux and tetrakistriphenyl-phosphino-Pd(0) (x/35 moles) in toluene (5 ml/mmol boronic acid derivative) is added. The mixture is refluxed for 24 hours and poured into acetone after cooling down to room temperature. After filtration the polymer is successively washed with acetone and aqueous HCI. Finally a solid, powder is obtained, which is soluble in chloroform, toluene and xylene. Thermal properties: no melting point, gradual decomposition above 250°C. For details of composition and characteristic properties see Table 1 below.
- ¹H-NMR; (CDCl₃):: δ(ppm): 0.7 - 1.8 (CH₂, CH₃ of n-hexyl), 2.63 (α-CH₂ of n-hexyl at phenylene adjacent to DPP), 2.42 (α-CH₂ of n-hexyl at phenylene adjacent to another phenylene), 3.84 (α-CH₂ of n-hexyl at DPP), 7.19 (m, CH of phenylene), 7.55 (d, CH of DPP), 7.93 (d, CH of DPP).
- UVNIS absorption (CHCl₃):: λₘₐₓ = 488 nm.
- Photoluminescence (CHCl₃):: λₘₐₓ = 544 nm.

Example 2: 433.9 mg of 1,4-diketo-2,5-di(i-pentyl)-3,6-di(4-bromophenyl)pyrrolo-[3.4-c]pyrrole, 500.0 mg of 2,5-di-i-pentoxybenzene-1,4-bis(boronic acid) and 302.0 mg of 2,5-dibromo-1,4-di-i-pentoxylbenzene are dissolved in 20 ml of tetrahydrofurane under a nitrogen atmosphere and 20 ml of a 1 N solution of NaHCO₃ in water is added. The solution is heated to reflux and 17 mg of tetrakistriphenylphosphino-Pd(0) in 5 ml tetrahydrofurane are added. The mixture is refluxed for 72 h and poured into methanol after cooling down to room temperature. After filtration the polymer is washed with water and recrystallized from chloroform by addition of methanol. A dark red powder is obtained having a molecular weight of M_{w} = 4500 g/mol (polymer 11, see Table below).
- ¹H-NMR (CDCl₃):: δ(ppm): 0.7 - 1.6 (CH₂, CH₃ of i-pentyl), 3.89 (α-CH₂ of i-pentyl at DPP), 3.95 (α-CH₂ of i-pentoxy at phenylene), 6.9 and 7.0, 7.6, 7.76 and 7.9 (aromatic protons of DPP and phenylene);
- UV/VIS absorption (CHCl₃):: λₘₐₓ = 493, 305 nm.
- Fluorescence:: λₘₐₓ = 558 nm.

**Table 1:**

| Composition and characteristic properties of (co)polymers. | | | | | |
|---|---|---|---|---|---|
| **Polymer** | **x** | **yield (%)** | **M**_{**w**}**[g/mol]** | **P**_{**w**} | **colour** |
| 1 | 1 | 69 | 5400 | 8 | deep orange |
| 2 | 0.65 | 73 | 6400 | 10 | orange |
| 3 | 0.50 | 84 | 21000 | 36 | orange |
| 4 | 0.45 | 79 | 19000 | 33 | orange |
| 5 | 0.25 | 71 | 6100 | 11 | orange |
| 6 | 0.10 | 65 | 9800 | 19 | pale orange |
| 7 | 0.05 | 62 | 3000 | 6 | pale orange |
| 8 | 0.01 | 58 | 2900 | 6 | brownish orange |
| 9 | 0.005 | 57 | 2700 | 6 | pale brown |
| 10 | 0 | 87 | 39000 | 80 | pale brown |
| 11 | 0.50 | 63 | 4500 | 7 | deep red |

P_{w} is defined as M_{w}/M, wherein M is the molecular weight of the corresponding monomer unit resp. the weighted monomer unit depending on x and y.
x is determined by ¹H-NMR-spectroscopy of the inventive polymers in CDCl₃.
Molecular weights are determined by size exclusion chromatography ("SEC") using a Waters/Millipore UV detector 481 and a SEC column combination (Latek/styragel 50/1000 nm pore size). All measurements are carried out in tetrahydrofurane at 45°C. The columns are calibrated versus commercially available polystyrene standards.

Example 3: 83 mg of polymer 1 are dissolved in 4.5 ml of chloroform. A glass substrate coated with indium-tin-oxide (ITO) (100 nm) and poly(dioxyethylene thienylene) ("PEDOT")/PSS (Baytron P® from Bayer AG) (50 nm) is used and coated with a film of polymer 1 (thickness of film: 100 nm) using spin-coating; the coating conditions comprise 1500 rotations per min for 10 s, the acceleration time being 1 s, 2000 rotations per min for 20 s, the acceleration being 1 s and 1000 rotations per min for 30 s, the delay time being 2 s. Subsequently the film is coated with a layer of Al with a thickness of 50 nm using vapor deposition (pressure: 0,0006 Pa (6·10⁻⁶ mbar)).

Electroluminescence measurements are carried out under an atmosphere of nitrogen using a HP 16442A test fixture with a home-made sample holder. The voltage is chosen in the range of from 0 to 20 V and the current is detected with a HP 4155A semiconductor parameter analyzer and the light power is measured using a Hamamatsu S2281-01 Silicon Photodiode. Electroluminescence spectra are measured using a LN/CCD detector equipped with an optical grating of 150 g/mm. At 15 V, the light power is 3·10⁻² mW/cm², the current density: 2·10⁻¹ A/cm² and λₘₐₓ = 623 nm.

Example 4: 120 mg of polymer 2 are dissolved in 5.5 ml of chloroform using spin-coating a film of a thickness of 100 nm is prepared on a glass substrate coated with ITO (100 nm) and PEDOT (50 nm); the coating conditions comprise 1500 rotations per min for 10 s, the acceleration time being 1 s, 2000 rotation per min for 20 s, the acceleration being 1 s and 1000 rotations per min for 30 s, the delay time being 2 s. Subsequently the film is coated with a layer of Al with thickness of 50 nm using vapor deposition (pressure: 0,0006 Pa (6·10⁻⁶ mbar)).

Electroluminescence properties are determined as described in ex. 2: at 15 V, the light power is 8·10⁻² mW/cm², the current density: 5·10⁻² A/cm², and λₘₐₓ = 623 nm.

Example 5: 80 mg of a polymer 3 are dissolved in 6 ml of chloroform. Using spin-coating a film of a thickness of 100 nm is prepared on a glass substrate coated with ITO (100 nm) and PEDOT (50 nm); the coating conditions comprise 1200 rotations per min for 10 s, the acceleration time being 3 s, 1800 rotations per min for 20 s, the acceleration being 3 s and 1000 rotations per min for 30 s, the delay time being 2 s. Subsequently the film is coated with a layer of Al with a thickness of 50 nm using vapor deposition (pressure: 0,0006 Pa (6·10⁻⁶ mbar)).

Electroluminescence properties are determined as described in ex. 2: at 15 V, the light power is 5·10⁻³ mW/cm², the current density: 5.5·10⁻² A/cm², and λₘₐₓ = 623 nm.

Example 6: 83 mg of polymer with 5 are dissolved in 6 ml of chloroform. Using spin-coating a film of a thickness of 100 nm is prepared on a glass substrate coated with ITO (100 nm) and PEDOT (50 nm); the coating conditions comprise 1800 rotations per min for 10 s, the acceleration time being 1 s, 2200 rotations per min for 20 s, the acceleration being 1 s and 1000 rotations per min for 30 s, the delay time being 2 s. Subsequently the film is coated with a layer of Al with a thickness of 50 nm using vapor deposition (pressure: 0,0006 Pa (6·10⁻⁶ mbar)).
Electroluminescence properties are determined as described in ex. 2: at 15 V, the light power is 8·10⁻⁴ mW/cm², the current density: 2·10⁻³ A/cm², and λₘₐₓ = 623 nm.

Example 7: 120 mg of polymer 6 are dissolved in 6 ml of chloroform. Using spin-coating a film of a thickness of 100 nm is prepared on a glass substrate coated with ITO (100 nm) and PEDOT (50 nm); the coating conditions comprise 1500 rotations per min for 10 s, the acceleration time being 1 s, 2000 rotations per min for 20 s, the acceleration being 1 s and 1000 rotations per min for 30 s, the delay time being 2 s. Subsequently the film is coated with a layer of Al with a thickness of 50 nm using vapor deposition (pressure: 0,0006 Pa (6·10⁻⁶ mbar)).

Electroluminescence properties are determined as described in ex. 2: at 15 V, the light power is 5·10⁻⁴ mW/cm², the current density: 1.5·10⁻³ A/cm², and λₘₐₓ = 623 nm.

Example 8: The same procedure as in example 3 was applied, except that Ca (100 nm) instead of Al is deposited.

Electroluminescence properties are determined as described in ex. 2: at 15 V, the light power is 4·10⁻³ mW/cm², the current density: 3·10⁻³ A/cm², and λₘₐₓ = 623 nm.

Example 9: 85 mg of polymer 1 are dissolved in 5 ml of chloroform. Using spin-coating a film of a thickness of 50 nm is prepared on a glass substrate coated with FTO (100 nm); the coating conditions comprise 1800 rotations per min for 10 s, the acceleration time being 1 s, 2200 rotations per min for 20 s, the acceleration being 1 s and 1000 rotations per min for 30 s, the delay time being 2 s. Subsequently the film is coated with a layer of Al with a thickness of 50 nm using vapour deposition (pressure: 0,0006 Pa (6*10⁻⁶ mbar)).

Electroluminescence properties (under N₂) at 14V: λₘₐₓ = 623 nm, light power: 3*10⁻³ W/cm², current density: 9*10⁻¹ A/cm².

Example 10: 70 mg of a polymer 3 are dissolved in 6 ml of chloroform. Using spin-coating a film of a thickness of 75 nm is prepared on a glass substrate coated with FTO; the coating conditions comprise 1500 rotations per min for 10 s, the acceleration time being 1 s, 200 rotations per min for 20 s, the acceleration being 1 s and 1000 rotations per min for 30 sec, the delay time being 2 s. Subsequently the film is coated with a layer of Al with a thickness of 50 nm using vapour deposition (pressure: 0,0006 Pa (6*10⁻⁶ mbar)).

Electroluminescence properties (under N₂) at 20V: λₘₐₓ = 623 nm, light power: 4*10⁻⁴ W/cm², current density: 4*10⁻² A/cm².

Example 11: 100 mg of polymer 2 are dissolved in 5.5 ml of chloroform. Using spin-coating a film of a thickness of 75 nm is prepared on a glass substrate coated with FTO; the coating conditions comprise 1800 rotations per min for 10 s, the acceleration time being 1 s, 2200 rotations per min for 20 s, the acceleration being 1 s and 1000 rotations per min for 30 s, the delay time being 2 s. Subsequently the film is coated with a layer of Al with a thickness of 50 nm using vapour deposition (pressure: 0,0006 Pa (6*10⁻⁶ mbar)).

Electroluminescence properties (under N₂) at 20V: λₘₐₓ = 623 nm, light power: 2*10⁻⁴ W/cm², current density: 6*10⁻² A/cm².

Example 12: 88 mg of polymer 11 are dissolved in 4 ml of chloroform. Using spin-coating a film of a thickness of 100 nm is prepared on a glass substrate coated with ITO (100 nm) and PEDOT (∼ 50 nm); the coating conditions comprise 1500 rotations per min for 10 s, the acceleration time being 3 s, 2000 rotations per min for 20 s, the acceleration being 1 s and 1000 rotations per min for 30 s, the delay time being 2 s. Subsequently the film is coated with a layer of Al with a thickness of 50 nm using vapour deposition (pressure: 0,0006 Pa (6*10⁻⁶ mbar)).

Electroluminescence properties (under N₂) at 20V: Broad El-Spectrum with λₘₐₓ = 727 nm, light power: 2*10⁻⁴ mW/cm², current density: 1*10⁻¹ A/cm².

Example 13: 88 mg of polymer 11 are dissolved in 4 ml of chloroform. Using spin-coating a film of a thickness of 100 nm is prepared on a glass substrate coated with ITO (100 nm); the coating conditions comprise 1500 rotations per min for 10 s, the acceleration time being 3 s, 2000 rotations per min for 20 s, the acceleration being 1 s and 1000 rotations per min for 30 s, the delay time being 2 s. Subsequently the film is coated with a layer of Al with a thickness of 50 nm using vapour deposition (pressure: 0,0006 Pa (6*10⁻⁶ mbar)).

Electroluminescence properties (under N₂) at 20V: Broad El-Spectrum with λₘₐₓ = 727 nm, light power: 1.5*10⁻⁴ mW/cm², current density: 3*10⁻¹ A/cm².

## Claims

1. Diketopyrrolopyrrole based polymers and copolymers comprising the following units 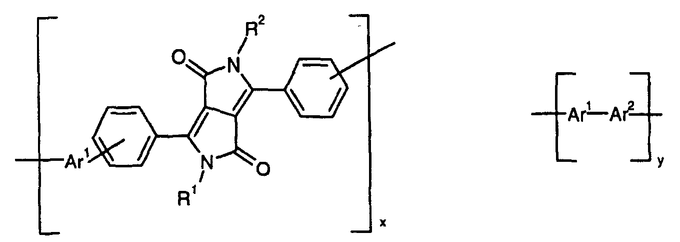 wherein x is chosen in the range of from 0.005 to 1, preferably from 0.01 to 1, and y from 0.995 to 0, preferably 0.99 to 0, and wherein x + y = 1, and
wherein Ar¹ and Ar² independently from each other stand for 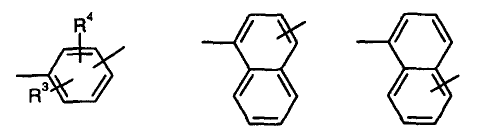 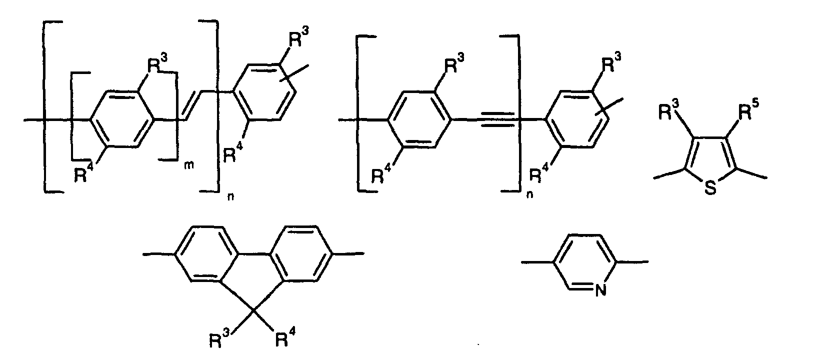 and m, n being numbers from 1 to 10, and
R¹ and R² independently from each other stand for H, C₁-C₁₈alkyl, -C(O)O-C₁-C₁₈alkyl, perfluoro-C₁-C₁₂alkyl, unsubstituted C₆-C₁₂aryl or C₆-C₁₂aryl substituted one to three times with C₁-C₁₂alkyl, C₁-C₁₂alkoxy, or halogen, C₁-C₁₂alkyl-C₆-C₁₂aryl, or C₆-C₁₂aryl-C₁-C₁₂alkyl,
R³ and R⁴ stand for hydrogen, C₁-C₁₂alkyl, C₁-C₁₂alkoxy, unsubstituted C₆-C₁₂aryl or C₆-C₁₂aryl substituted one to three times with C₁-C₁₂alkyl, C₁-C₁₂alkoxy, or halogen, or perfluoro-C₁-C₁₂alkyl, and
R⁵ stands for C₁-C₁₂alkyl, C₁-C₁₂alkoxy, unsubstituted C₆-C₁₂aryl or C₆-C₁₂aryl substituted one to three times with C₁-C₁₂alkyl, C₁-C₁₂alkoxy, or halogen, or perfluoro-C₁-C₁₂alkyl.

2. A diketopyrrolopyrrole based copolymer according to claim 1 wherein Ar¹ stands for

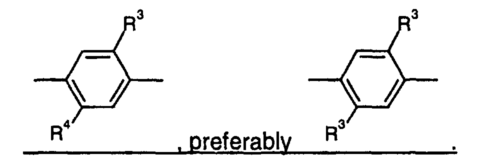

3. A diketopyrrolopyrrole based copolymer according to claim 1 wherein and Ar² stands

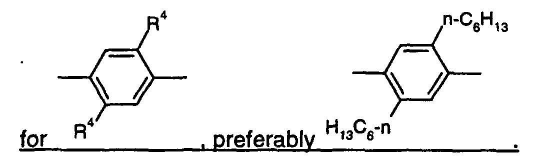

4. A diketopyrrolopyrrole based copolymer according to claim 1 comprising the following units 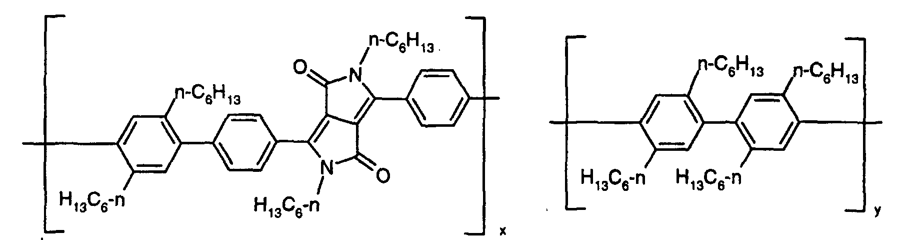 or

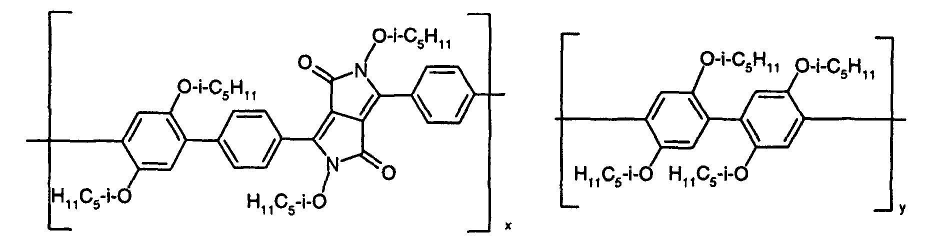

5. Process for the preparation of a DPP polymer according to claim 1 which comprises reacting a DPP derivative of formula II 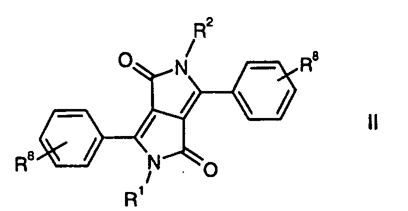 wherein R¹ and R² are defined as in claim 1, and
R⁸ stands for halogen, or E having the meaning of 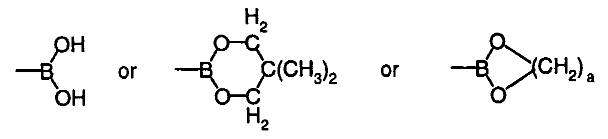 wherein a is 2 or 3,
with boronic acid derivative III 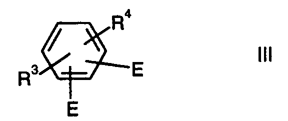 or - in case R⁸ is not halogen - 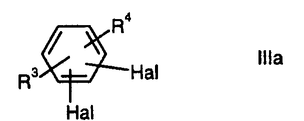 wherein Hal stands for halogen, and R³ and R⁴ are defined as in claim 1,
and optionally with dihalophenyl compound IV 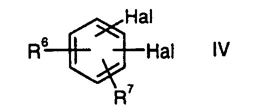 wherein R⁶ and R⁷, independently from each other have the meaning of hydrogen, C₁-C₁₂alkyl, C₁-C₁₂alkoxy, unsubstituted C₆-C₁₂aryl or C₆-C₁₂aryl substituted one to three times with C₁-C₁₂alkyl, C₁-C₁₂alkoxy, or halogen, or perfluoro-C₁-C₁₂alkyl.

6. Use of DPP based polymers according to any of claims 1 to 4 for the preparation of electronic and photonic devices, preferably of electroluminescent devices.

7. An electronic or photonic device, preferably electroluminescent device, comprising a DPP based polymer according to any of claims 1 to 4.

8. Mixture of a DPP based polymer according to any of claims 1 to 4 and at least another polymer compatible therewith.

## Patentansprüche

1. Auf Diketopyrrolopyrrol basierende Polymere und Copolymere, umfassend die nachstehenden Einheiten 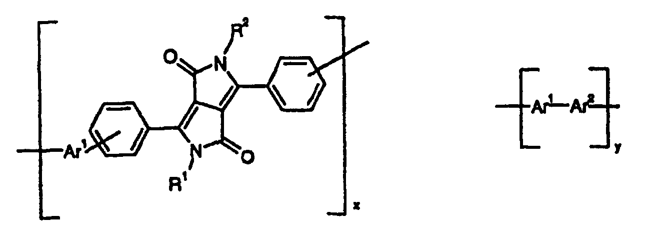 worin x aus dem Bereich von 0,005 bis 1, vorzugsweise 0,01 bis 1, und y aus 0,995 bis 0, vorzugsweise 0,99 bis 0, ausgewählt ist, und wobei x + y = 1, und
worin Ar¹ und Ar² unabhängig voneinander für 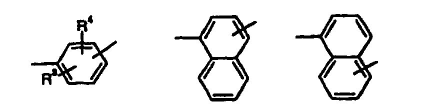 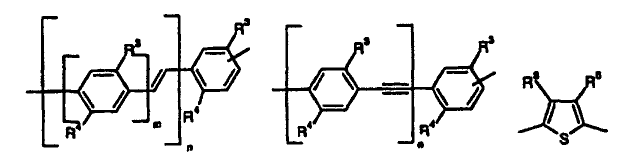 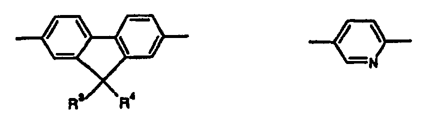 stehen und m, n Zahlen von 1 bis 10 sind, und
R¹ und R² unabhängig voneinander für H, C₁-C₁₈-Alkyl, - C(O)O-C₁-C₁₈-Alkyl, Perfluor-C₁-C₁₂-alkyl, unsubstituiertes C₆-C₁₂-Aryl oder C₆-C₁₂-Aryl, ein- bis dreifach substituiert mit C₁-C₁₂-Alkyl, C₁-C₁₂-Alkoxy oder Halogen, C₁-C₁₂-Alkyl-C₆-C₁₂-aryl oder C₆-C₁₂-Aryl-C₁-C₁₂-alkyl stehen,
R³ und R⁴ für Wasserstoff, C₁-C₁₂-Alkyl, C₁-C₁₂-Alkoxy, unsubstituiertes C₆-C₁₂-Aryl oder C₆-C₁₂-Aryl, ein- bis dreifach substituiert mit C₁-C₁₂-Alkyl, C₁-C₁₂-Alkoxy oder Halogen, oder Perfluor-C₁-C₁₂-alkyl stehen, und
R⁵ für C₁-C₁₂-Alkyl, C₁-C₁₂-Alkoxy, unsubstituiertes C₆-C₁₂-Aryl oder C₆-C₁₂-Aryl, ein- bis dreifach substituiert mit C₁-C₁₂-Alkyl, C₁-C₁₂-Alkoxy oder Halogen, oder Perfluor-C₁-C₁₂-alkyl steht.

2. Auf Diketopyrrolopyrrol basierendes Copolymer nach Anspruch 1, worin Ar¹ für 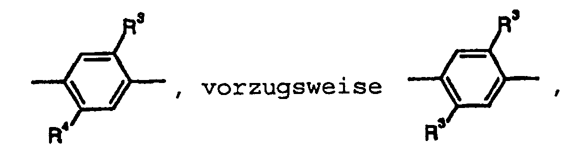 steht.

3. Auf Diketopyrrolopyrrol basierendes Copolymer nach Anspruch 1, worin Ar² für 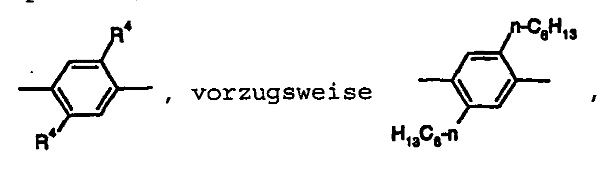 steht.

4. Auf Diketopyrrolopyrrol basierendes Copolymer nach Anspruch 1, umfassend die nachstehenden Einheiten 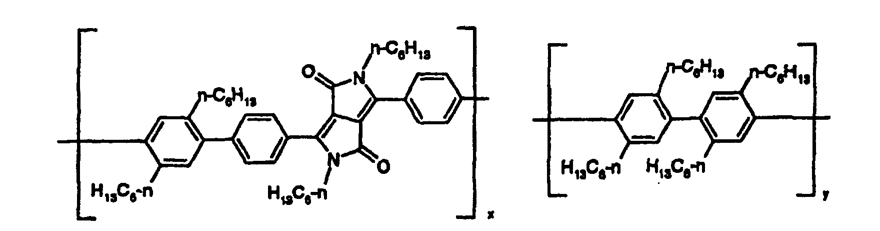 oder

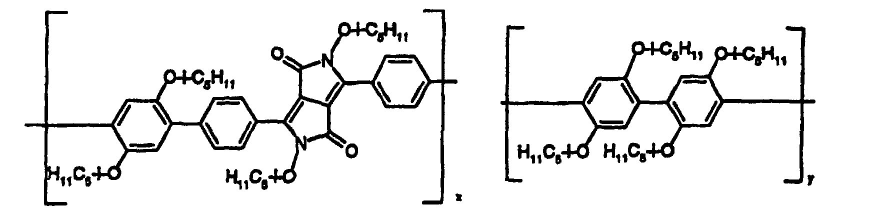

5. Verfahren zur Herstellung eines DPP-Polymers nach Anspruch 1, das Umsetzen eines DPP-Derivats der Formel II 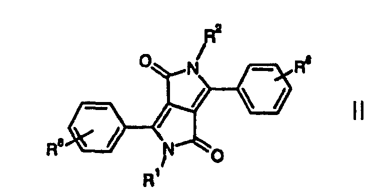 worin R¹ und R² wie in Anspruch 1 definiert sind und
R⁸ für Halogen oder E mit der Bedeutung von 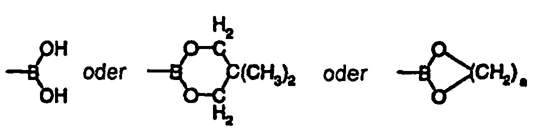 worin a 2 oder 3 ist, steht,
mit Boronsäurederivat III 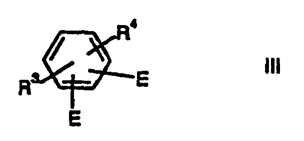 oder - im Fall, wenn R⁸ nicht Halogen ist - 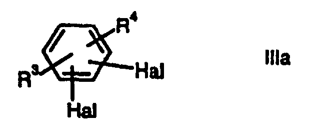 worin Hal für Halogen steht, und R³ und R⁴ wie in Anspruch 1 definiert sind,
und gegebenenfalls mit Dihalogenphenylverbindung IV 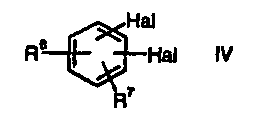 worin R⁶ und R⁷ unabhängig voneinander die Bedeutung von Wasserstoff, C₁-C₁₂-Alkyl, C₁-C₁₂-Alkoxy, unsubstituiertem C₆-C₁₂-Aryl oder C₆-C₁₂-Aryl, ein- bis dreifach substituiert mit C₁-C₁₂-Alkyl, C₁-C₁₂-Alkoxy oder Halogen, oder Perfluor-C₁-C₁₂-alkyl aufweisen, umfasst.

6. Verwendung von auf DPP-basierenden Polymeren nach einem der Ansprüche 1 bis 4 zur Herstellung von elektronischen und photonischen Bauelementen, vorzugsweise von elektrolumineszierenden Bauelementen.

7. Elektronisches oder photonisches Bauelement, vorzugsweise elektrolumineszierendes Bauelement, umfassend ein auf DPP basierendes Polymer nach einem der Ansprüche 1 bis 4.

8. Gemisch eines auf DPP basierenden Polymers nach einem der Ansprüche 1 bis 4 und mindestens eines weiteren damit verträglichen Polymers.

## Revendications

1. Polymères et copolymères à base de dicétopyrrolopyrrole comprenant les blocs suivants 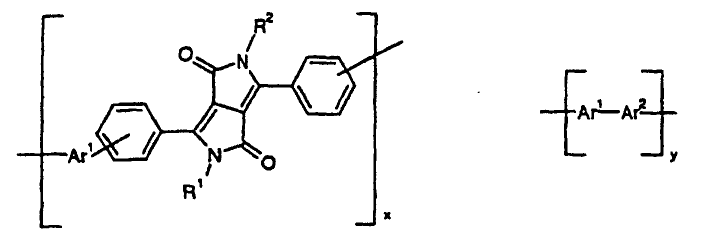 dans lesquels x est choisi dans la plage de 0,005 à 1, de préférence de 0,01 à 1, et y de 0,995 à 0, de préférence de 0,99 à 0, et dans lesquels x + y = 1, et dans lesquels Ar¹ et Ar² représentent indépendamment l'un de l'autre 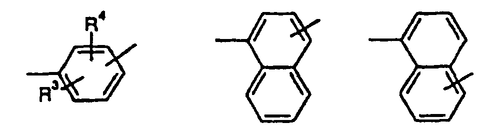 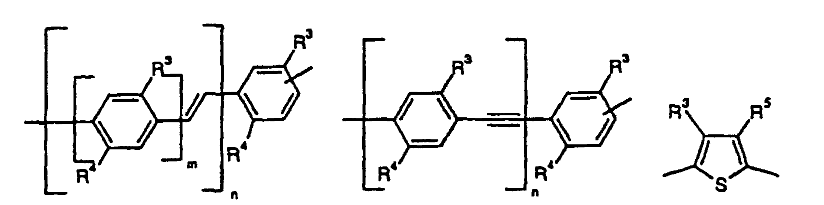 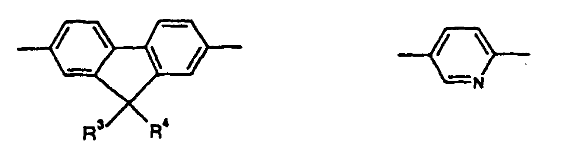 et m, n étant des nombres de 1 à 10, et
R¹ et R² représentent indépendamment l'un de l'autre H, un alkyle en C₁ à C₁₈, un -C(O)O-alkyle en C₁ à C₁₈, un perfluoroalkyle en C₁ à C₁₂, un aryle en C₆ à C₁₂ non substitué ou un aryle en C₆ à C₁₂ substitué une à trois fois par un alkyle en C₁ à C₁₂, ou avec un alcoxy en C₁ à C₁₂, ou avec un halogène, un alkyle en C₁ à C₁₂ -aryle en C₆ à C₁₂, ou bien un aryle en C₆ à C₁₂ -alkyle en C₁ à C₁₂,
R³ et R⁴ représentent un atome d'hydrogène, un alkyle en C₁ à C₁₂, un alcoxy en C₁ à C₁₂, un aryle en C₆ à C₁₂ non substitué ou un aryle en C₆ à C₁₂ substitué un à trois fois avec un alkyle en C₁ à C₁₂, ou avec un alcoxy en C₁ à C₁₂, ou avec un halogène, ou un perfluoroalkyle en C₁ à C₁₂, et
R⁵ représente un alkyle en C₁ à C₁₂, un alcoxy en C₁ à C₁₂, un aryle en C₆ à C₁₂ non substitué ou un aryle en C₆ à C₁₂ substitué une à trois fois avec un alkyle en C₁ à C₁₂, ou avec un alcoxy en C₁ à C₁₂, ou avec un halogène, ou un perfluoroalkyle en C₁ à C₁₂.

2. Copolymères à base de dicétopyrrolopyrrole selon la revendication 1, dans lequel Ar¹ représente

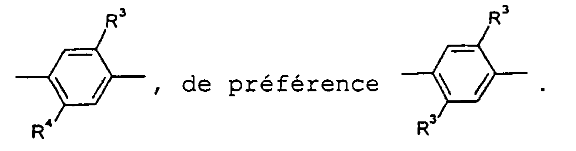

3. Copolymères à base de dicétopyrrolopyrrole selon la revendication 1, dans lequel Ar² représente

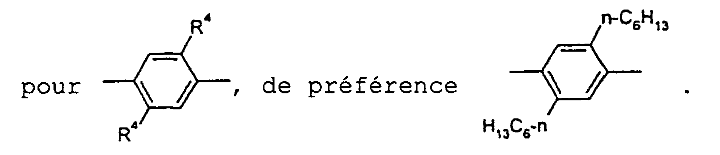

4. Copolymères à base de dicétopyrrolopyrrole selon la revendication 1, comprenant les blocs suivants 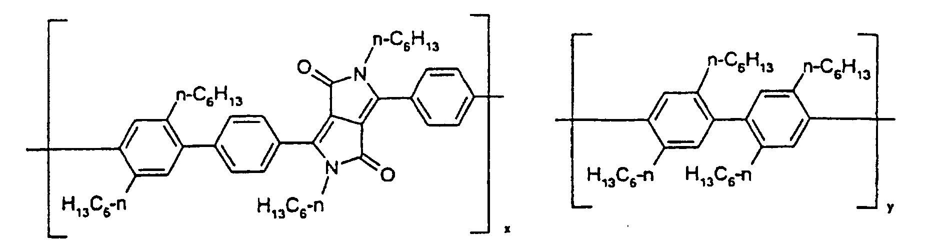 ou

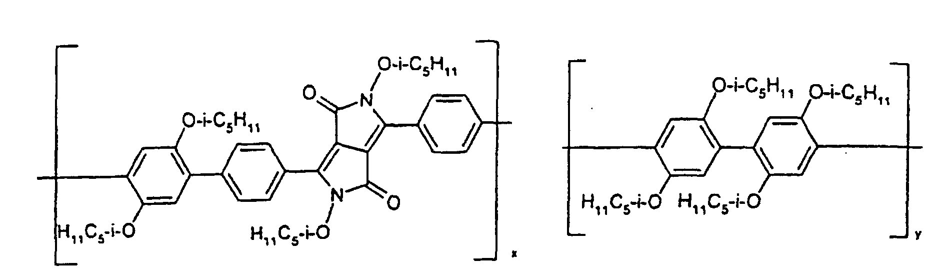

5. Procédé destiné à la préparation d'un polymère à base de DPP selon la revendication 1 qui comprend la mise en réaction d'un dérivé de DPP selon la formule II 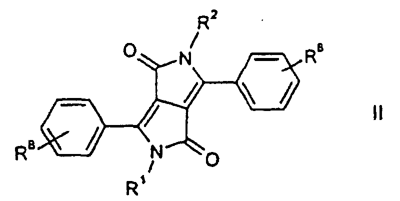 dans laquelle R¹ et R² sont définis comme dans la revendication 1, et
R⁸ représente un atome d'halogène, ou bien E ayant pour signification 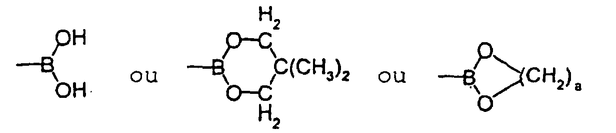 où a vaut 2 ou 3,
avec un dérivé d'acide borique III 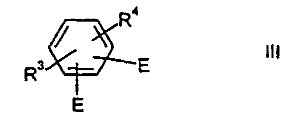 ou bien - dans le cas où R⁸ n'est pas un halogène - 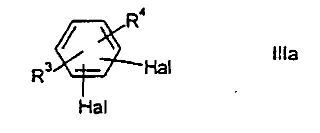 où Hal représente un halogène, et R³ ainsi que R⁴ sont définis comme dans la revendication 1, et optionnellement avec un composé de dihalophényle IV 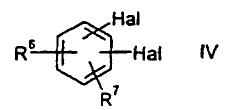 dans lequel R⁶ et R⁷, indépendamment l'un de l'autre, ont pour signification un atome d'hydrogène, un alkyle en C₁ à C₁₂, un alcoxy en C₁ à C₁₂, un aryle en C₆ à C₁₂ non substitué ou un aryle en C₆ à C₁₂ substitué une à trois fois avec un alkyle en C₁ à C₁₂, ou avec un alcoxy en C₁ à C₁₂, ou avec un halogène, ou un perfluoro-alkyle en C₁ à C₁₂.

6. Utilisation de polymères à base de DPP selon l'une quelconque des revendications 1 à 4 destinée à la préparation de dispositifs électroniques et opto-électroniques, de préférence de dispositifs électroluminescents.

7. Dispositif électronique ou photoélectronique, de préférence dispositif électroluminescent, comprenant un polymère à base de DPP selon l'une quelconque des revendications 1 à 4.

8. Mélange d'un polymère à base de DPP selon l'une quelconque des revendications 1 à 4 et d'au moins un autre polymère compatible avec celui-ci.
